# EUROPEAN PATENT APPLICATION

(11) **EP 4 797 311 A1**
(43) Date of publication of application: **26.08.2026**
(21) Application number: 24895669.0
(22) Date of filing: 19.07.2024
(51) Int. Cl.: H01J 37/317, H01J 37/30, H01L 21/67, H01J 37/10

(54) **RADIO-FREQUENCY EXTRACTION HIGH-ENERGY HYDROGEN-HELIUM ION IMPLANTER**

(30) Priority: 27.11.2023 CN 202311591496
(71) Applicant: Qingdao SRI Intellectual Technology Co., Ltd., Qingdao, Shandong 266000 (CN)
(72) Inventor: NIE, Xiang, Beijing Road, China (Shandong) Pilot Free Trade Zone Qingdao Area Qingdao, Shandong 266000 (CN); CHEN, Xianglong, Beijing Road, China (Shandong) Pilot Free Trade Zone Qingdao Area Qingdao, Shandong 266000 (CN); LIU, Qiang, Beijing Road, China (Shandong) Pilot Free Trade Zone Qingdao Area Qingdao, Shandong 266000 (CN); SONG, Yunyang, Beijing Road, China (Shandong) Pilot Free Trade Zone Qingdao Area Qingdao, Shandong 266000 (CN)
(74) Representative: Bergenstråhle & Partners AB
(86) International application number: PCT/CN2024/106424
(87) International publication number: WO 2025/112566

(57) **Abstract**

The embodiment of the present disclosure provides a radio frequency extraction high-energy hydrogen-helium ion implanter, and relates to the technical field of semiconductor ion implantation. The specific implementation of the radio frequency extraction high-energy hydrogen-helium ion implanter comprises: generating an alternating voltage of a radio frequency extraction electrode through a radio frequency power supply and a first radio frequency acceleration unit; periodically extracting ion beams through the alternating voltage from an ion source; periodically bunching the ion beams in a Z transmission direction through velocity dispersion; transmitting to a radio frequency acceleration system after being shaped by a first electrostatic quadrupole lens for beam shaping and a second electrostatic quadrupole lens for beam shaping; transmitting the ion beams accelerated to a high-energy state by the radio frequency acceleration system to an energy analyzer for filtering; expanding, through an electric field scanning system, the ion beams filtered by the energy analyzer; generating parallel ion beams through a beam parallelization lens; and finally transmitting to a process chamber to complete implantation. The implementation can reduce the size of a high-energy ion implanter, reduce the machine footprint, and reduce the implantation costs.

## Description

### CROSS-REFERENCE TO RELATED APPLICATIONS

The present application claims the priority to the Chinese patent application with the application No. CN202311591496.X and the application title "RADIO FREQUENCY EXTRACTION HIGH-ENERGY HYDROGEN-HELIUM ION IMPLANTER", which is filed with the Patent Office of the People's Republic of China on November 27, 2023, and the entire contents thereof are incorporated in the present application by reference.

### BACKGROUND OF THE INVENTION

### 1. Technical Field

The present disclosure relates to the technical field of semiconductor ion implantation, and in particular to a radio frequency extraction high-energy hydrogen-helium ion implanter.

### 2. Description of Related Art

In the manufacturing process of semiconductor components, an important step involves implanting ions to semiconductor wafers in vacuum so as to add impurities into a crystal lattice of the semiconductor wafers, thereby altering the conductivity of the semiconductor wafers. The device used for the process is called an ion implanter. The ion implanter typically ionizes semiconductor impurity atoms into ions, accelerates, and then implants into the semiconductor wafers.

With the high integration of semiconductor components, it is necessary to inject high-energy ions deeper into semiconductor wafers, and the corresponding device is called a high-energy ion implanter. The components used for ion beam acceleration in high-energy ion implanters typically employ tandem electrostatic accelerators. The structure of the electrostatic accelerator becomes increasingly complex as the voltage increases. The gradually increasing insulation distance significantly enlarges the physical size of the equipment. Meanwhile, the acceleration voltage is generally less than 500KV. For processes requiring high-energy MeV (Million electron Volts) implantation, electrostatic accelerators cannot meet the energy requirements in different scenarios. Therefore, linear accelerators that utilize radio-frequency acceleration principles to accelerate ions to MeV energies (Patent No. US4667111) are gradually being widely used. When high-energy ion implanters employ radio frequency acceleration systems, various ions generated by the ion source are extracted by an extraction voltage, filtered by a mass analyzer, and then enter the radio frequency acceleration system to accelerate as many ion beams as possible to the required energy. Afterwards, ions of the required energy are filtered out by an energy analyzer, scanned and parallelized, and then implanted into wafers in a process chamber.

High-energy ion implanters used to commonly employ Batch devices. For high-quality imaging components such as CCDs, which require ion implantation at ultra-high energies (3-8 MeV) and allow an implantation angle error of around 0.1°, Batch devices with large injection angle deviations are difficult to apply in such scenarios. Therefore, in recent years, single-wafer high-energy ion implanters are used. The single-wafer high-energy ion implanters parallelize ion beams which is electronically scanned, ensuring not only uniform implantation doses within wafer planes, but also uniform implantation angles, thus solving the problem of implantation angle deviations.

Extraction electrodes of the high-energy ion implanter utilize DC voltages. To achieve the effect of ion beam bunching, Buncher (e.g. device for beam bunching) technology is introduced to improve the bunching effect of the ion beams in a radio frequency acceleration system, so as to increase the longitudinal transmission rate of the beams. The Buncher is positioned at the forefront of the radio frequency acceleration system (Patent No. CN1310279C). Since a certain space is required for longitudinal bunching of the beams, the radio frequency acceleration units of the radio frequency acceleration system needs to maintain a certain distance from the Buncher, which increases the length of the radio frequency acceleration system, leading to an increase in the volume and machine floor space of the radio frequency acceleration system. On the other hand, the high-energy ion implanter requires a mass analyzer to pick out ion masses, which is also large in size, and thus increasing the cost of the machine.

### BRIEF SUMMARY OF THE INVENTION

In view of this, the embodiment of the present disclosure provides a radio frequency extraction high-energy hydrogen-helium ion implanter, to solve the problems that a conventional high-energy ion implanter is large in size, large in machine floor space and high implantation cost.

To achieve the purpose above, according to one aspect of the present disclosure, a radio frequency extraction high-energy hydrogen-helium ion implanter is provided, including:
an ion source, a radio frequency extraction electrode, a suppression electrode, a three-coordinate ground electrode, a first electrostatic quadrupole lens for beam shaping, a second electrostatic quadrupole lens for beam shaping, a radio frequency acceleration system, an energy analyzer, an electric field scanning system, a beam parallelization lens, and a process chamber, wherein:
The alternating voltage of the radio frequency extraction electrode is generated through a radio frequency power supply and a first radio frequency acceleration unit; ion beams are periodically extracted from the ion source by the alternating voltage; the ion beams are periodically bunched in a Z transmission direction through velocity dispersion; the ion beams are transmitted to the radio frequency acceleration system after being shaped by the first electrostatic quadrupole lens for beam shaping and the second electrostatic quadrupole lens for beam shaping; the ion beams accelerated to a high-energy state by the radio frequency acceleration system are transmitted to the energy analyzer for filtering; the ion beams filtered by the energy analyzer are expanded, in at least one direction, through the electric field scanning system; parallel ion beams are generated through the beam parallelization lens; and finally the ion beams are transmitted to the process chamber to complete implantation.

By applying the alternating voltage on the radio frequency extraction electrode through the radio frequency power supply and the first radio frequency acceleration unit, without the need for a mass analyzer and a Buncher, one or more technical solutions provided in the embodiments of the present application can achieve the following technical effects:
(1) The radio frequency extraction electrode combines the functions of a Buncher and a direct current extraction electrode into one, eliminating the need for the Buncher in the radio frequency acceleration system of a high-energy ion implanter, thus providing an injection solution which is simple and compact in structure and large in beam for lightweight high-energy hydrogen-helium ion implantation, having the advantages of saving machine space and minimizing beam loss.
(2) The radio frequency extraction high-energy hydrogen-helium ion implanter of the present disclosure is high in ion homogenization degree, eliminating the need for the mass analyzer. By utilizing the filtering characteristics of the radio frequency extraction electrode, the shaping electrostatic quadrupole lenses, and the radio frequency acceleration system, specific ions with a low relative atomic mass can be selected and accelerated. Even if ions or electrons related to working elements in an ion source chamber enter the radio frequency acceleration system, due to the charge-to-mass ratio being significantly different from that of hydrogen or helium, these stray particles are difficult to be accelerated and can be easily filtered using the energy analyzer. Therefore, by eliminating the bulky and heavy mass analyzer, the machine space can be saved, and the machine cost can be reduced.
(3) In principle, for the direct interaction between the radio frequency extraction electrode and the ion beam, another DC(direct current) power supply is required on the radio frequency extraction electrode so as to suppress electrons from entering the beam transport system. Usually, an isolation transformer can be used to apply a high voltage to the ion source to achieve the same effect. Since the amplitude of the alternating voltage applied to the radio frequency extraction electrode is greatly reduced (for example, peak-to-peak value of 30 kV), compared to a traditional direct current ion source voltage of 70-90 kV, the isolation transformer is greatly reduced in volume and weight, or even can be omitted, further saving the machine space and reducing the machine cost.
(4) The shape of the radio frequency extraction electrode needs to be determined based on the structure of the extraction slit of the ion source, and the shape and size of the extraction slit are closely related to the requirement for extraction current intensity. In traditional scenarios where mass analyzers are used, when the beam extraction and deflection of irregular-shaped extraction slits are calculated, either details are ignored and a transmission matrix is adopted for calculation, or full three-dimensional electromagnetic simulation is employed, making the design simulation highly challenging and delaying the development of new models, and generally only minor modifications can be made in certain typical designs. After adopting linear extraction in the present invention, beam optics can exhibit a two-dimensional axisymmetric and mirror symmetric structure, greatly reducing the difficulty of design simulation. Precedent scenarios of linear electron optics and ion optics can be utilized, and even for irregular-shaped extraction slits, the size and angle of ion beams can be relatively easily controlled.
(5) The lateral fluctuation of beams caused by the radio frequency extraction electrode is real. Therefore, electrons that cause the early neutralization and non-acceleration of hydrogen or helium positive ions are suppressed by the suppression electrode and the three-coordinate ground electrode to prevent electrons from entering a subsequent beam channel. Then, the beams are shaped and suppressed in fluctuation transversely through the shaping electrostatic quadrupole lens, thereby gradually approaching the "O" shaped beam cross-section desired by the radio frequency acceleration system.
(6) The present disclosure is abundant in beam profile shaping and bunching length, allowing for maximum separation from an acceleration region. Unlike traditional high-energy ion implanters, where beam profile shaping and beam bunching should be simultaneously completed within a limited distance between the Buncher and the radio frequency acceleration system, the present disclosure improves the shaping and acceleration effects.

### BRIEF DESCRIPTION OF DRAWINGS

In the following description of exemplary embodiments in conjunction with the accompanying drawings, more details, features and advantages of the present disclosure are disclosed, and in the drawings:
FIG. 1(a) shows a schematic diagram of a radio frequency extraction high-energy hydrogen-helium ion implanter according to an exemplary embodiment of the present disclosure;
FIG. 1(b) shows a schematic diagram of a radio frequency power supply and a first radio frequency acceleration unit according to an exemplary embodiment of the present disclosure;
FIG. 2 shows a schematic diagram I of the relative relationship of an ion source voltage and an alternating voltage of a radio frequency extraction electrode according to an exemplary embodiment of the present disclosure;
FIG. 3 shows a schematic diagram II of the relative relationship of the ion source voltage and the alternating voltage of the radio frequency extraction electrode according to an exemplary embodiment of the present disclosure;
FIG. 4 shows a schematic diagram III of the relative relationship of the ion source voltage and the alternating voltage of the radio frequency extraction electrode according to an exemplary embodiment of the present disclosure;
FIG. 5 shows a schematic diagram of a cross section of a ribbon ion source and the radio frequency extraction electrode according to an exemplary embodiment of the present disclosure; and
FIG. 6 shows a schematic diagram of a cross section of a spherical ion source and the radio frequency extraction electrode according to an exemplary embodiment of the present disclosure.

### DETAILED DESCRIPTION OF THE EMBODIMENTS

The embodiments of the present disclosure will be described in more detail below with reference to the drawings. Although some embodiments of the present disclosure are shown in the drawings, it should be understood that the present disclosure can be implemented in various forms and should not be construed as limited to the embodiments set forth herein. Instead, these embodiments are provided to more thoroughly and completely understand the present disclosure. It should be understood that, the drawings and embodiments of the present disclosure are only for illustrative purposes and are not intended to limit the scope of the present disclosure.

The term "including" and its variations used herein are open inclusions, i.e., "including but not limited to". The term "based on" means "based at least in part on". The term "in an embodiment of the present disclosure" means "at least one embodiment"; the term "another exemplary embodiment" means "at least one other embodiment". The relevant definitions of other terms will be given in the following description. It needs to be noted that, the concepts such as "first" and "second" mentioned in the present disclosure are only used for distinguishing different apparatuses, modules or units, and are not intended to limit the order or interdependence relations of the functions executed by these apparatuses, modules or units.

It needs to be noted that, the modifications of "one" and "a plurality of" mentioned in the present disclosure are schematic rather than restrictive, and those skilled in the art should understand that, unless otherwise explicitly stated in the context, the "one" and "a plurality of" should be understood as "one or more".

The solutions of the present disclosure will be described below with reference to the accompanying drawings.

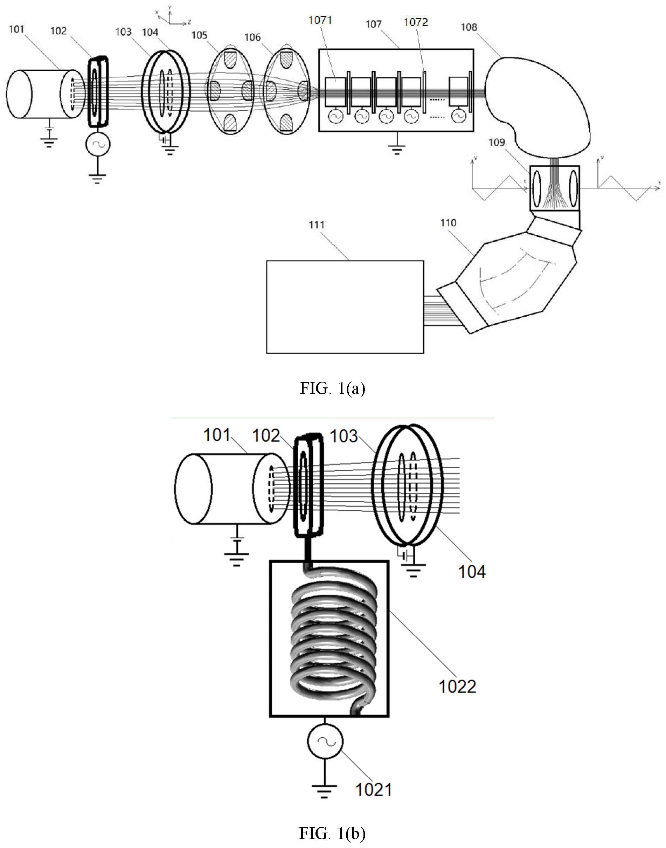

FIG. 1(a) shows a schematic diagram of a radio frequency extraction high-energy hydrogen-helium ion implanter according to an exemplary embodiment of the present disclosure. As shown in FIG. 1(a), the radio frequency extraction high-energy hydrogen-helium ion implanter of the present disclosure includes: an ion source 101, a radio frequency extraction electrode 102, a suppression electrode 103, a three-coordinate ground electrode 104, a first electrostatic quadrupole lens for beam shaping 105, a second electrostatic quadrupole lens for beam shaping 106, a radio frequency acceleration system 107, an energy analyzer 108, an electric field scanning system 109, a beam parallelization lens 110, and a process chamber 111.

Ion beams are extracted through the radio frequency extraction electrode 102 from the ion source 101. The ion beams are periodically bunched in a Z transmission direction through velocity dispersion. The ion beams directly enter into the radio frequency acceleration system 107 after being shaped by the first electrostatic quadrupole lens for beam shaping 105 and the second electrostatic quadrupole lens for beam shaping 106. The ion beams accelerated to a high-energy state by the radio frequency acceleration system 107 are filtered by the energy analyzer 108 to obtain ion beams of required energy. The filtered ion beams pass through the electric field scanning system 109 and the beam parallelization lens 110 and are transmitted to the process chamber 111. The process chamber 111 is equipped with a target stage movement mechanism, the target stage movement mechanism has a motion dimension perpendicular to the scanning direction of the electric field scanning system 109, to complete ion beam implantation in the process chamber 111.

Furthermore, the present disclosure is applicable to ions with a low relative atomic mass (such as hydrogen or helium), resulting in a high degree of homogenization of extracted ions. For instance, high-purity hydrogen gas is ionized in the ion source 101 to produce H⁺, H₂⁺, and H₃⁺, or high-purity helium gas is ionized in the ion source 101 to produce He⁺ and He²⁺.

In the embodiment of the present disclosure, as shown in FIG. 1(a), the ion source 101 generates positive ions with a low relative atomic mass. An alternating voltage is applied to the radio frequency extraction electrode 102, and thus the ion beams are periodically extracted through the radio frequency extraction electrode 102 from the ion source 101. As shown in FIG. 1(b), the alternating voltage on the radio frequency extraction electrode 102 is generated by a radio frequency power supply 1021 and a first radio frequency acceleration unit 1022. Utilizing a structure similar to that of a Buncher, the radio frequency power supply 1021 feeds a radio frequency power into the first radio frequency acceleration unit 1022. The main architecture of the first radio frequency acceleration unit 1022 is an LC resonant circuit (refer to Patent No. US6262638), including a capacitor C and an inductor L, ensuring that the first radio frequency acceleration unit 1022 is always in a resonant state. A resonant high voltage is applied to the radio frequency extraction electrode 102, and the resonant frequency of the first radio frequency acceleration unit 1022 is determined by the capacitor C and the inductor L. Due to the close proximity to the ion source 101, the radio frequency extraction electrode 102 is not in ideal vacuum, resulting in a sinusoidal high voltage amplitude on the radio frequency extraction electrode 102 that is typically between 0-30 kV, and a higher amplitude may lead to electrical breakdown. However, the radio frequency extraction electrode 102 is only used to extract ions and facilitate ion bunching, without being responsible for accelerating the ions. The final beam energy of the high-energy ion implanter is mainly achieved by the radio frequency acceleration system 107, therefore, the radio frequency extraction electrode 102 does not need to apply a higher voltage.

Different from the factor that uniform ion beams are extracted from a direct current power supply, the radio frequency extraction electrode of the present disclosure applies the alternating voltage to extract periodically pulsating ion beams. As the alternating voltage varies, velocity dispersion is applied to the ions, resulting in dense and sparse bunching of the ion beams in subsequent motion, providing a good periodic ion bunch for the radio frequency acceleration system, and reducing longitudinal beam loss during radio frequency acceleration. On one hand, since the radio frequency extraction electrode 102 combines the capabilities of a direct current extraction electrode of a traditional high-energy ion implanter and the Buncher in a radio frequency system, the Buncher is not required in the radio frequency acceleration system 107. On the other hand, the present disclosure is applicable to ions with low relative atomic mass. Due to the velocity dispersion of the extracted ions, a mass analyzer is not required for ion filtering, thus significantly reducing beam loss and making beam simulation design easier. In addition, for a microwave ion source that requires isolated waveguides, system components can be simplified. In summary, technical effects of saving machine space and reducing machine cost can be achieved.

As shown in FIG. 1(a), periodically extracted ion beams are periodically bunched in the Z transmission direction by velocity dispersion. To prevent electrons from the ion source 101 from being introduced into a subsequent beam channel, in addition to installing a suppression electrode 103 to suppress electrons, the voltage of the ion source 101 can also be appropriately increased. The periodically bunched ion beams pass through the suppression electrode 103 and the three-coordinate ground electrode 104 and then reach a beam shaping region.

As shown in FIG. 1(a), the movement of the suppression electrode 103 and the three-coordinate ground electrode 104 causes changes in capacitance C, leading to a slight shift in the resonant frequency of the first radio frequency acceleration unit 1022. Therefore, the first radio frequency acceleration unit 1022 also includes a frequency compensation motion device to compensate for the impact on the radio frequency caused by the simultaneous movement of the suppression electrode 103 and the three-coordinate ground electrode 104. As shown in FIG. 1(b), the radio frequency extraction electrode 102 is positioned close to the ion source 101 and far from the suppression electrode 103 and the three-coordinate ground electrode 104, so as to reduce the impact of the moving suppression electrode 103 and the three-coordinate ground electrode 104 on the resonant frequency, while better controlling the ion source 101 to extract ions in a desired manner.

As shown in FIG. 1(a), the beam shaping region includes a first electrostatic quadrupole lens for beam shaping 105 and a second electrostatic quadrupole lens for beam shaping 106, which are used to shape the irregular ion beam passing through the three-coordinate ground electrode 104 into an "O"-shaped beam required by the radio frequency acceleration system 107. The first electrostatic quadrupole lens for beam shaping 105 and the second electrostatic quadrupole lens for beam shaping 106 can preliminarily suppress the disturbance of the ion beams by the radio frequency extraction electrode 102, bunching the ion beams in the longitudinal direction (i.e., Z direction) and preventing lateral fluctuations of ions. At the same time, the first electrostatic quadrupole lens for beam shaping 105 and the second electrostatic quadrupole lens for beam shaping 106 can reduce the self-expansion of low-speed ion beams caused by space charge forces before acceleration, ensuring the "O"-shaped beam shaping effect of the ion beams. It should be noted that the number of the beam shaping electrostatic quadrupole lenses included in the beam shaping region can be selectively set according to needs. The first electrostatic quadrupole lens for beam shaping and the second electrostatic quadrupole lens for beam shaping disclosed in the present disclosure are merely examples. Alternatively, other beam optical elements can be arranged in the beam shaping region according to needs to meet actual shaping requirements.

As shown in FIG. 1(a), the radio frequency acceleration system 107, the energy analyzer 108, the electric field scanning system 109, the beam parallelization lens 110 and the process chamber 111 are basically consistent with those of a conventional high-energy ion implanter. The ion beams accelerated to a high-energy state by the radio frequency acceleration system 107 are filtered by the energy analyzer 108, and the filtered ion beams are scanned and expanded in at least one direction (e.g., the X direction) by the electric field scanning system 109, and then parallel ion beams are generated by the beam parallelization lens 110. Finally, the ion beams are transmitted to the process chamber 111 to complete ion beam implantation. The number of the second radio frequency acceleration unit 1071 and the quadrupole lenses 1072 in the radio frequency acceleration system 107 is determined by an acceleration energy range covered by the machine model.

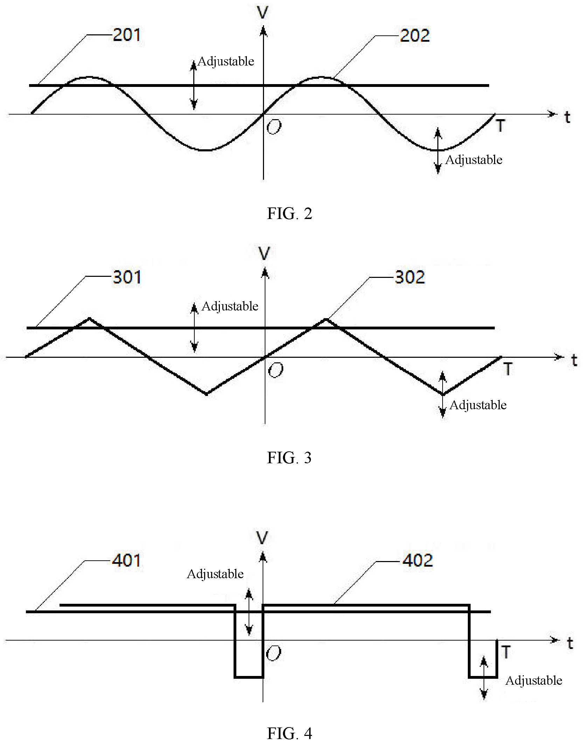

In the embodiment of the present disclosure, the alternating voltage applied to the radio frequency extraction electrode 102 can be a sinusoidal voltage, a triangular wave voltage, or a pulse voltage. With the machine ground of the high-energy ion implanter as the reference ground potential, the voltage 201 applied to the ion source 101 while sinusoidal voltage 202 applied to the radio frequency extraction electrode 102 is shown in FIG. 2, the voltage 301 applied to the ion source 101 while triangular wave voltage 302 applied to the radio frequency extraction electrode 102 is shown in FIG. 3, and the voltage 401 applied to the ion source 101 while pulse voltage 402 applied to the radio frequency extraction electrode 102 is shown in FIG. 4. Since positive ions are generally extracted, the ion source voltages 201, 301 and 401 are generally positive and adjustable, primarily used to suppress the extraction of electrons from the ion source 101. The ion source voltages 201, 301 and 401 are direct current voltages, and the amplitudes depend on the amplitude of the alternating voltage applied to the radio frequency extraction electrode 102, but do not need to be as high as 70-90 kV. Compared to a traditional DC ion source voltage ranging from 70-90 kV, an isolation transformer and a voltage-withstanding distance in the ion source region are significantly reduced, saving the space and reducing the machine floor space, so that the space and weight required for the isolation transformer in the present disclosure are significantly reduced, and the isolation transformer can be even omitted, with no exposed high-voltage electrodes in the source region. Meanwhile, ion source voltages 201, 301 and 401 also play a necessary role in the energy calibration of the high-energy ion implanter.

Furthermore, as shown in FIG. 2, the amplitude of the sinusoidal voltage 202 is adjustable, but usually does not exceed 30 kV. An extraction frequency *f*_{extraction} applicable to ion acceleration falls within a radio frequency band. In the industrial field, frequencies of 13.56 MHz, 27.12 MHz and 40.68 MHz are commonly chosen. Within the frequency range, the sinusoidal voltage is much easier for ion extraction compared to the alternating voltage of other types. For an extraction frequency *f*_{extraction} of light ions such as hydrogen and helium, higher frequencies can be considered. The relationship between the extraction frequency *f*_{extraction} of the sinusoidal voltage 202 and the acceleration frequency *f*_{acceleration} of the radio frequency acceleration system 107 is shown in formula (1) below:
${f}_{acceleration} = n \times {f}_{extraction} , \left(n=1,2,3,…\right)$

In the formula, the relationship between the extraction period *T*_{extraction} and the extraction frequency *f*_{extraction} of the sinusoidal voltage 202 is *T*_{extraction} = 1/*f*_{extraction}, wherein *n* = 1 is the easiest to achieve. In the case of *n* = 1, the alternating voltage on the radio frequency extraction electrode 102 maintains phase-locked with the radio frequency voltage of each second radio frequency acceleration unit 1071 in the radio frequency acceleration system 107, enabling efficient acceleration. Moreover, the phase difference between the alternating voltage in the radio frequency extraction electrode 102 and each radio frequency voltage in the second radio frequency acceleration units 1071 can be adjusted, facilitating fine adjustment of energy and ion beams current in high-energy acceleration.

As shown in FIG. 3, the amplitude of the triangular wave voltage 302 is adjustable, but usually does not exceed 30 kV. The relationship between the extraction frequency *f*_{extraction} of the triangular wave voltage 302 and the acceleration frequency *f*_{acceleration} of the radio frequency acceleration system 107 also meets the formula (1) above. Within the frequency ranges of 13.56 MHz, 27.12 MHz and 40.68 MHz, a triangular wave voltage is much more difficult to generate than the sinusoidal voltage, but the triangular wave voltage can achieve a better bunching effect for the ion beams.

As shown in FIG. 4, the amplitude of the pulse voltage 402 is adjustable, but usually does not exceed 30 kV. The relationship between the extraction frequency *f*_{extraction} of the pulse voltage 402 and the acceleration frequency *f*_{acceleration} of the radio frequency acceleration system 107 also meets the formula (1) above. Within the frequency ranges of 13.56 MHz, 27.12 MHz and 40.68 MHz, an ultra-narrow pulse voltage is much more difficult to generate than the sinusoidal voltage. However, due to the constant voltage during a pulse segment of the pulse voltage, ions extracted by the radio frequency extraction electrode 102 are consistent in velocity, which can directly provide the radio frequency acceleration system 107 with ion bunches with small velocity dispersion, making subsequent acceleration easier.

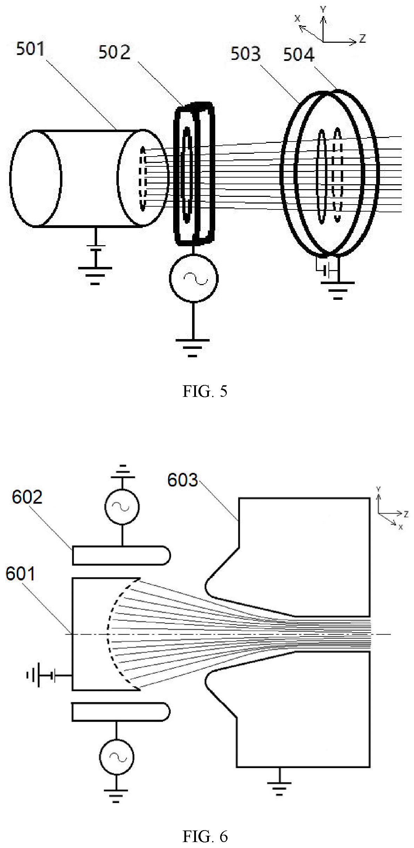

In the embodiment of the present disclosure, the ion beams extracted from the ion source 101 and the radio frequency extraction electrode 102 are diverse in shape, as shown in FIG. 5. The ion source 101 of the radio frequency extraction high-energy hydrogen-helium ion implanter of the present disclosure adopts a ribbon ion source 501, and the ribbon ion source 501 extracts ribbon ion beams. Correspondingly, through holes of the radio frequency extraction electrode 502, the suppression electrode 503 and the three-coordinate ground electrode 504 are all ribbon-shaped, and ribbon ion beams have the advantage of being large in beam current. The radio frequency extraction electrode 502 extracts from the side of the ribbon ion source 501, and the suppression electrode 503 is still used to suppress electrons from entering the subsequent acceleration system and to suppress secondary electron back-bombard, which can be adjusted according to the situation. When the voltage on the radio frequency extraction electrode 502 changes to be lower than the ion source voltage of the ribbon ion source 501, positive ions are extracted and enter the through holes of the radio frequency extraction electrode 502. After passing through the through holes of the radio frequency extraction electrode 502, due to the voltage of the radio frequency extraction electrode 502 already being higher than that of the subsequent three-coordinate ground electrode 504, the ions have the momentum to continue moving through the suppression electrode 503 and the three-coordinate ground electrode 504. Light H⁺ and He⁺ ions do not move as slowly as heavy ions, so the inter-electrode spacing between the radio frequency extraction electrode 502 and the ribbon ion source 501, between the radio frequency extraction electrode 502 and the suppression electrode 503, and between the radio frequency extraction electrode 502 and the three-coordinate ground electrode 504 is not too small. As shown in FIG. 5, the radio frequency extraction electrode 502 is close to the extraction end of the ribbon ion source 501 and far from the suppression electrode 503 and the three-coordinate ground electrode 504, forming an intense electric field between the radio frequency extraction electrode 502 and the ribbon ion source 501, and the ion velocity can be adjusted. The ion beams transition from velocity modulation to density modulation during the journey from the radio frequency extraction electrode 502 to the suppression electrode 503, which are not affected despite the weaker electric field in the space, and gradually form ion bunches in the Z direction of motion. Therefore, the radio frequency extraction electrode 502 can simultaneously achieve the effects of extracting ions and promoting ion bunching. It should be noted that the extraction frequency *f*_{extraction} and inter-electrode spacing can be designed and simulated in detail according to needs to meet actual bunching requirements.

Alternatively, as shown in FIG. 6, the ion source 101 of the radio frequency extraction high-energy hydrogen-helium ion implanter of the present disclosure can also adopt a spherical ion source 601, and the spherical ion source 601 extracts spherical ion beams. Correspondingly, through holes of the radio frequency extraction electrode 602 and the three-coordinate ground electrode 603 are both "O" shaped, and the spherical ion beams have the advantage of being large in beam current. The extraction frequency *f*_{extraction} and inter-electrode spacing can be designed and simulated in detail according to needs to meet actual bunching requirements.

Furthermore, when the spherical ion source 601 is used, whether suppression electrodes need to be added can be determined according to the motion path of electrons and the back-bombard of secondary electrons.

## Claims

1. A radio frequency extraction high-energy hydrogen-helium ion implanter, **characterized by** comprising: an ion source (101), a radio frequency extraction electrode (102), a suppression electrode (103), a three-coordinate ground electrode (104), a first electrostatic quadrupole lens for beam shaping (105), a second electrostatic quadrupole lens for beam shaping (106), a radio frequency acceleration system (107), an energy analyzer (108), an electric field scanning system (109), a beam parallelization lens (110), and a process chamber (111), wherein:
The alternating voltage of the radio frequency extraction electrode (102) is generated through a radio frequency power supply (1021) and a first radio frequency acceleration unit (1022); ion beams are periodically extracted from the ion source (101) by the alternating voltage; the ion beams are periodically bunched in a Z transmission direction through velocity dispersion; the ion beams are transmitted to the radio frequency acceleration system (107) after being shaped by the first electrostatic quadrupole lens for beam shaping (105) and the second electrostatic quadrupole lens for beam shaping (106); the ion beams accelerated to a high-energy state by the radio frequency acceleration system (107) are transmitted to the energy analyzer (108) for filtering; the ion beams filtered by the energy analyzer (108) are expanded , in at least one direction, through the electric field scanning system (109); parallel ion beams are generated through the beam parallelization lens (110); and finally the ion beams are transmitted to the process chamber (111) to complete implantation.

2. The radio frequency extraction high-energy hydrogen-helium ion implanter according to claim 1, **characterized in that** the extraction frequency *f*_{extraction} of the alternating voltage applied to the radio frequency extraction electrode (102) and the radio frequency *f*_{acceleration} applied to each second radio frequency acceleration unit (1071) in the radio frequency acceleration system (107) meet the following relationship: ${f}_{acceleration} = n \times {f}_{extraction} , \left(n=1,2,3,…\right) .$

3. The radio frequency extraction high-energy hydrogen-helium ion implanter according to claim 1, **characterized in that** the alternating voltage applied to the radio frequency extraction electrode (102) is a sinusoidal voltage, a triangular wave voltage or a pulse voltage.

4. The radio frequency extraction high-energy hydrogen-helium ion implanter according to claim 1, **characterized in that** the ion source (101) is a spherical ion source, and the radio frequency extraction electrode (102) extracts ions from a side; or,
the ion source (101) is a ribbon ion source, and the through hole of the radio frequency extraction electrode (102) is ribbon-shaped.
